(19)

Europäisches
Patentamt
European
Patent Office
Office européen
des brevets

(11)  **EP 2 197 034 B1**

(12)  **EUROPEAN PATENT SPECIFICATION**

(45) Date of publication and mention
of the grant of the patent:
**19.09.2012  Bulletin 2012/38**

(51) Int Cl.:
***H01L 29/786*** *(2006.01)*

(21) Application number: **09014995.6**

(22) Date of filing: **03.12.2009**

(54) **Field effect transistor and display apparatus**

Feldeffekttransistor und Anzeigevorrichtung

Transistor à effet de champ et appareil d'affichage

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **12.12.2008  JP 2008317286
28.09.2009  JP 2009222514**

(43) Date of publication of application:
**16.06.2010  Bulletin 2010/24**

(60) Divisional application:
**11009309.3 / 2 423 966**

(73) Proprietor: **Canon Kabushiki Kaisha
Ohta-ku
Tokyo (JP)**

(72) Inventors:
• **Ueda, Miki
Tokyo (JP)**

• **Iwasaki, Tatsuya
Tokyo (JP)**
• **Itagaki, Naho
Tokyo (JP)**
• **Goyal, Amita
Tokyo (JP)**

(74) Representative: **Weser, Thilo
Weser & Kollegen
Patentanwälte
Radeckestraße 43
D-81245 München (DE)**

(56) References cited:
**WO-A1-2005/074038      WO-A1-2008/133345
WO-A1-2008/133456      US-A1- 2005 199 880
US-A1- 2008 191 204      US-A1- 2008 296 568**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

Field of the Invention

The present invention relates to a field-effect transistor including an amorphous oxide semiconductor. In particular, it relates to a field-effect transistor used for a display apparatus, e.g., an organic electroluminescent display, an inorganic electroluminescent display, or a liquid crystal display.

Description of the Related Art

A thin film transistor (TFT), which is one of field-effect type including an oxide semiconductor, has attracted attention as a driver of an organic EL display, a liquid crystal display, a paper-like display, or the like.

In particular, the TFT including the oxide semiconductor is expected to be applied to not only the display, but also a wider range of uses taking advantages of features, e.g., a large field-effect mobility and, in addition, capability of being formed at low temperatures and transparency.

For example, a thin film transistor, in which an In-Ga-Zn-O based (In, Ga, and Zn-containing oxide based) amorphous oxide is used for a channel layer, has been known.

See for example US 2005/199880 A1, WO 2008/133456 A1, or WO 2008/133345 A1.

US Patent Application Publication US2008/0191204(corresponding to the preamble of claim 1), and US 2008/296 568 A1 report a thin film transistor, in which a channel layer having a double-layer structure is applied in order to reduce degradation of characteristics due to plasma.

However, in order to use the TFT including the oxide material in industry, reduction of element characteristic variations relative to a large substrate area is required in addition to high performance.

In order to reduce element characteristic variations, it is desired that characteristic variations resulting from compositional variations of a semiconductor layer constituting a channel layer of the TFT are small, that is, the composition dependence of the element characteristics is small. In the case where an element exhibiting such a small composition dependence is applied, a TFT array substrate having high uniformity can be obtained relatively easily. This is very advantageous in display and other uses from the viewpoint of the production cost.

Furthermore, the TFT having high performance can be used for a drive TFT and a switching TFT of an active matrix organic light-emitting diode(AMOLED).

SUMMARY OF THE INVENTION

The present invention in its first aspect provides a field-effect transistor as specified in claims 1 to 9.

The present invention in its second aspect provides a method for manufacturing a field-effect transistor as specified in claim 10.

The present invention in its third aspect provides a display apparatus as specified in claim 11.

According to aspects of the present invention, since a specific laminated configuration of the present invention is applied to a channel layer, a TFT having excellent electric characteristics and exhibiting small changes in characteristics with respect to compositional variations can be realized.

Further features of the present invention will become apparent from the following description of exemplary embodiments with reference to the attached drawings.

The reference example is outside the scope of the invention as claimed here.

BRIEF DESCRIPTION OF THE DRAWINGS

Figs. 1A to 1C are sectional views schematically showing a thin film transistor including a channel formed from first and second amorphous oxide layers according to an embodiment of the present invention.

Figs. 2A and 2B are diagrams showing examples of In composition dependence of the current-voltage characteristic of TFTs according to the present invention and a comparative example, respectively.

Fig. 3 is a graph showing an example of changes in On Off current ratio versus the composition ratio, In/(In + Zn), of a first amorphous oxide semiconductor layer in a TFT according to an embodiment of the present invention.

Fig. 4 is a graph showing an example of changes in field-effect mobility versus the composition ratio, In/(In + Zn), of the first amorphous oxide semiconductor layer in a TFT according to an embodiment of the present invention.

Fig. 5 is a graph showing an example of value changes in subthreshold swing value S (V/dec) versus the composition ratio, In/(In + Zn), of the first amorphous oxide semiconductor layer in a TFT according to an embodiment of the present invention.

Fig. 6 is a diagram schematically showing a film formation system used for forming a channel layer of a field-effect transistor according to an embodiment of the present invention.

Fig. 7 is a schematic sectional view of a display apparatus according to an embodiment of the present invention.

Fig. 8 is a schematic sectional view of a display apparatus according to an embodiment of the present invention.

Fig. 9 is a diagram schematically showing the configuration of a display apparatus, in which pixels including organic EL elements and thin film transistors are arranged two-dimensionally.

Fig. 10 is a graph showing the Id-Vd characteristic of a TFT according to an embodiment of the present invention.

Fig. 11 is a diagram showing the In composition dependence of the current-voltage characteristic of a TFT (after annealing at 250°C in air for 1 hour) according to the present invention.

Fig. 12 is a graph showing an example of changes in field-effect mobility versus the composition ratio, In/(In + Zn), of the first amorphous oxide semiconductor layer in a TFT according to an embodiment of the present invention.

Figs. 13A to 13D are diagrams showing the transfer characteristic and the field-effect mobility of a TFT according to an embodiment of the present invention.

Fig. 14 is a graph showing the transfer characteristic of a TFT according to the reference example.

DESCRIPTION OF THE EMBODIMENTS

The present inventors noted an amorphous oxide semiconductor that serves as a material for a channel layer of a field-effect transistor, and conducted intensive research. In particular, the present inventors conducted intensive research for the purpose of reducing the composition dependence of a TFT having a Zn-In-O based channel layer. As a result, it was found that, for example, a channel layer, in which an amorphous Zn-In-O based film and an amorphous Zn-In-Ge(or Si)-O based film were laminated, was able to be used.

In aspects of the present invention, the Zn-In-O based film refers to an oxide semiconductor film comprising at least one element selected from the group consisting of Zn and In. Furthermore, the Zn-In-Ge(or Si)-O based film refers to an oxide semiconductor film comprising at least one element selected from the group consisting of Zn, In, and Ge or an oxide semiconductor film comprising at least one element selected from the group consisting of Zn, In, and Si.

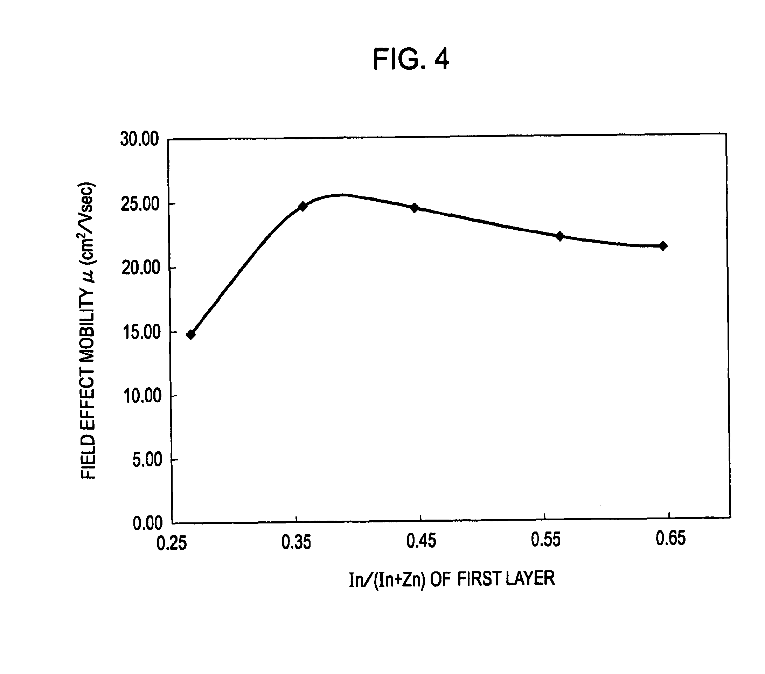

In aspects of the present invention, the above-described laminated configuration is applied to a channel layer and, thereby, a TFT having a relatively large field-effect mobility can be obtained as compared with that in the case where a channel formed from a single layer of In-Ga-Zn-O or a channel formed from a single layer of In-Ge-Zn-O is used. Specifically, the field-effect mobility with respect to the configuration of an In-Ga-Zn-O single layer is about 10 $cm^2$/Vsec, whereas with respect to the TFT including the channel having the laminated configuration according to aspects of the present invention, a field-effect mobility of 20 $cm^2$/Vsec or more can be obtained. In Fig. 4, the field-effect mobility of the TFT according to aspects of the present invention is indicated in a graph.

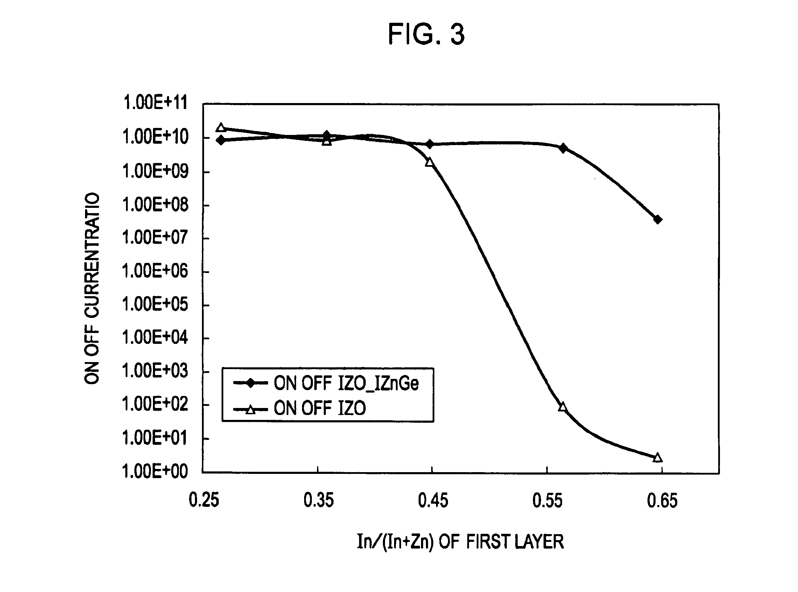

Furthermore, in aspects of the present invention, the above-described laminated configuration is applied to a channel layer and, thereby, a TFT exhibiting small changes in characteristics due to compositional variations can be realized as compared with that in the case where a channel formed from an In-Zn-O single layer is used. The present inventors reported that in the case where the channel formed from the In-Zn-O single layer was used, a good switching characteristic was obtained in the vicinity of In:Zn = 4:6 and the characteristic has a dependence on the In:Zn ratio (Phys. stat. sol. (a)205, No. 8, 1915-1919 (2008)). In the case where the laminated configuration according to aspects of the present invention is applied, a good switching characteristic can be obtained with respect to a wider range of In:Zn ratio. Fig. 3 shows the composition dependence of the On Off current ratio. In Fig. 3, white triangles indicate the case where the channel formed from an In-Zn-O single layer is used and black quadrangles indicate the case where the laminated channel composed of Zn-In-O (first layer) and Zn-In-Ge-O (second layer) is used. It is clear that the TFT including the laminated channel according to aspects of the present invention exhibits smaller composition dependence of the On Off current ratio. Moreover, it is clear that large On Off current ratios are obtained over a wide range of In/(In + Zn) values.

Although the reasons for the above-described effect are not certain, the consideration will be described below.

In aspects of the present invention, it is important to adopt the laminated configuration of at least two layers of amorphous oxide semiconductor layers having specific compositions as the channel layer of a field-effect transistor. Initially, the Zn-In-O film, which is a material having a high electron mobility, serving as a first amorphous oxide semiconductor layer is disposed on the side in contact with a gate insulating film. It is believed that a large current in an On state, i.e. a large field-effect mobility, is made possible by disposing the oxide semiconductor layer at the location. Next, the Zn-In-Ge-O film serving as a second amorphous oxide semiconductor layer is disposed (laminated) in contact with the above-described first amorphous oxide semiconductor layer and, thereby, the Zn-In-O film is protected from the environment, e.g., the air or vacuum, and the performance intrinsic to the Zn-In-O film can be delivered. Furthermore, it is believed that good interface characteristics, semiconductor characteristics, and, furthermore, electric connection between an electrode and a channel can be ensured by employing the laminated configuration according to aspects of the present invention and a function, which is difficult for a single layer to realize, is realized.

Here, features of the Zn-In-Ge(or Si)-O film which constitutes characteristic portion of the laminated configuration according to aspects of the present invention and which is applied to the second amorphous oxide semiconductor layer, will be described. According to the findings of the present inventors, if Ge or Si, which is a group IV element, is added to an amorphous oxide semiconductor, the carrier concentration can be reduced effectively. In addition, the carrier concentration can be controlled (increased or decreased) by addition of a relatively small amount of Ge or Si as compared with that of Ga (group III element). Moreover, the stability (resistance to change due to external causes) of the resistivity and other electrical properties toward the environment (the air, water, and the like) is improved by adding Ge or Si to the amorphous oxide semiconductor.

It is the feature portion of aspects of the present invention that the amorphous oxide semiconductor containing the group IV element having the above-described features and the Zn-In-O based amorphous oxide semiconductor having a high mobility as a feature are laminated so as to form a laminated structure. In particular, the Zn-In-Ge-O system, in which Ge is added to the Zn-In-O system, is applied to the second amorphous oxide semiconductor layer, the configuration, in which the Zn-In-O based amorphous oxide semiconductor is applied, is selected and, thereby, a configuration, in which a difference in composition ratio between the first amorphous oxide semiconductor layer and the second amorphous oxide semiconductor layer, can be formed. In the case where such a configuration is employed, the continuity of physical properties between the two layers is enhanced and a good, stable interface can be realized. Since the good (electrical defects are few) interface can be realized, a TFT exhibiting excellent stability toward the environment and excellent operational stability can be realized while the feature, that is, a high mobility, of the Zn-In-O based film is maintained.

The laminated configuration of the above-described channel layer according to aspects of the present invention not only allows the second amorphous oxide semiconductor layer to physically protect the first amorphous oxide semiconductor layer, but also improves the electrical characteristics (device characteristics) significantly by employing the laminated configuration as compared with that in the case of the single layer.

Furthermore, in aspects of the present invention, a high field mobility (for example, 20 $cm^2$/Vsec) at the same level as that of the Zn-In-O single layer channel is obtained. From based on this fact as well, it is believed that a large current in an On state, i.e. a large field-effect mobility, is made possible because the Zn-In-O film, which is a material having a high field mobility, is in contact with the gate insulating film.

As a result, changes in characteristics along with compositional variations are small, as described above, and a TFT having further excellent characteristics can be realized.

The embodiments to execute aspects of the present invention will be described below with reference to drawings.

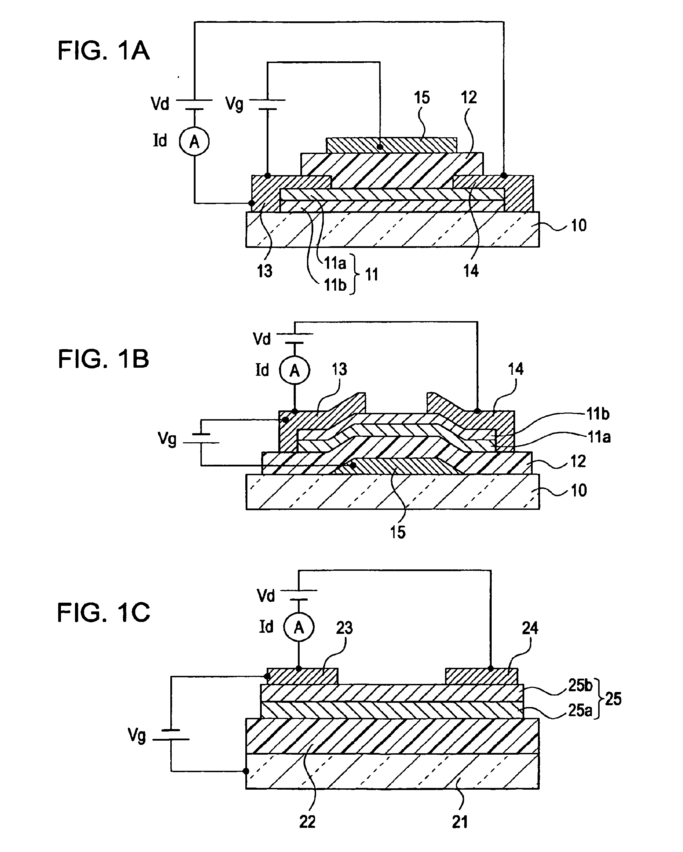

Figs. 1A to 1C are sectional views schematically showing a thin film transistor according to an embodiment of the present invention.

In Fig. 1A and Fig. 1B, reference numeral 10 denotes a substrate, reference numeral 11 denotes a channel layer formed from an oxide semiconductor layer according to aspects of the present invention, reference numeral 12 denotes a gate insulating layer, reference numeral 13 denotes a source electrode, reference numeral 14 denotes a drain electrode, and reference numeral 15 denotes a gate electrode. Reference numeral 11a denotes a first amorphous oxide semiconductor layer and reference numeral 11b denotes a second amorphous oxide semiconductor layer.

In Fig. 1C, a channel layer 25 formed from the oxide semiconductor layer according to aspects of the present invention is disposed on a substrate 21 provided with thermally oxidized $SiO_2$ serving as a gate insulator 22. Reference numeral 23 denotes a source electrode, and reference numeral 24 denotes a drain electrode. The substrate 21 is formed from $n^+$-Si and functions as a gate electrode. Reference numeral 25a denotes a first amorphous oxide semiconductor layer and reference numeral 25b denotes a second amorphous oxide semiconductor layer.

Fig. 1A shows an example of a top gate structure including the gate insulating layer 12 and the gate electrode 15 on the semiconductor channel layer 11. Fig. 1B shows an example of a bottom gate structure including the gate insulating layer 12 and the semiconductor channel layer 11 on the gate electrode 15. Fig. 1C shows another example of the bottom gate transistor.

In aspects of the present invention, the configuration of the TFT is not limited to the above-described structure and can be applied to any structure of, for example, top gate or bottom gate type, stagger type, reverse stagger type, coplanar type, and reverse coplanar type.

The field-effect transistor is a three-terminal device including the gate electrode 15, the source electrode 13, and the drain electrode 14. The field-effect transistor is an electronic device which can control a drain current Id passing through the channel layer when a voltage Vg is applied to the gate electrode and, thereby, controls a current passing between the source electrode and the drain electrode. The individual layers will be described below.

Channel layer

Features of the thin film transistor according to aspects of the present invention are that the channel layer has a laminated configuration comprising the first amorphous oxide semiconductor layer 11a and the second amorphous oxide semiconductor layer 11b and, furthermore, the materials for individual layers. In aspects of the present invention, the first amorphous oxide semiconductor layer 11a is disposed between the gate insulating layer 12 and the second amorphous oxide semiconductor layer 11b while being in contact with the gate insulating layer 12.

Furthermore, a part of the above-described second amorphous oxide semiconductor layer can be disposed between the source electrode or the drain electrode and the above-described first amorphous oxide semiconductor layer.

The first amorphous oxide semiconductor layer 11a according to aspects of the present invention is formed from an amorphous oxide semiconductor layer comprising at least one element selected from the group consisting of Zn and In. In particular, an amorphous oxide comprising both elements of Zn and In (amorphous Zn-In-O) can be used. Also, amorphous In-Sn-O, amorphous In-O, amorphous In-Ge-O, amorphous Zn-Sn-O, amorphous In-Zn-Ga-O, and the like can be used.

In aspects of the present invention, as for the composition ratio of the first amorphous oxide semiconductor layer, the composition ratio, Zn/(In + Zn), of Zn contained in the first amorphous oxide semiconductor layer can be 0.3 or more, and less than 0.75. In one version, the composition ratio, Zn/(In + Zn) of Zn contained in the first amorphous oxide semiconductor layer may be less than 0.4.

The second amorphous oxide semiconductor layer 11b according to aspects of the present invention is formed from an amorphous oxide comprising at least one element selected from the group consisting of Ge and Si, and at least one element selected from the group consisting of Zn and In. In particular, an amorphous oxide comprising all of the elements Zn, In, and Ge (amorphous Zn-In-Ge-O) can be used. Also, Zn-In-Si-O, Zn-Sn-Ge-O, In-Ge-O, Zn-Ge-O, In-Sn-Ge-O, and the like can be used.

Since the first amorphous oxide semiconductor layer 11a and the second amorphous oxide semiconductor layer 11b according to aspects of the present invention are formed from materials having different compositions, the individual amorphous oxide semiconductor layers can function synergistically and, thereby, the effects according to aspects of the present invention are exerted.

According to aspects of the present invention, the above-described amorphous oxides of the first and second amorphous oxide semiconductor layers contain oxygen at a largest content among all elements contained in the oxides, and then, the above-described individual elements are contained. In this connection, other elements besides the above-described elements may also be contained as impurities, within the bounds of not adversely affecting the semiconductor characteristics.

For example, an amorphous oxide comprising Zn-In-Ge-O contains oxygen as having the largest content among all the elements, and contains zinc (or indium) as having the second largest content, indium (or zinc) as having the third largest content, and germanium as having the fourth largest content. The composition ratio, Ge/(In + Zn + Ge), of Ge contained in the second amorphous oxide semiconductor layer according to aspects of the present invention can be 0.01 or more, and 0.4 or less. In particular, Ge/(In + Zn + Ge) can be 0.03 or more, and 0.15 or less.

A TFT having excellent electrical characteristics and exhibiting small element characteristic variations due to the composition can be realized by using the above-described laminated channel structure and combinations of the materials for the individual layers.

According to aspects of the present invention, the film thickness of the first amorphous oxide semiconductor layer 11a can be specified to be 10 nm or more, and 50 nm or less. In the case where the film thickness is 10 nm or more, the TFT operation can be conducted stably at a larger current. On the other hand, if the film thickness is too large, it becomes difficult to realize a normally-off TFT. Therefore, in particular, the upper limit can be specified to be 30 nm or less.

Furthermore, the film thickness of the second amorphous oxide semiconductor layer 11b can be specified to be 10 nm or more, and 50 nm or less.

In the case where the film thickness of the second amorphous oxide semiconductor layer 11b is 10 nm or more, the first amorphous oxide semiconductor can be protected, and a function of enhancing the stability toward the environment can be performed. Moreover, regarding the configuration in which a part of the second amorphous oxide semiconductor layer is disposed between the source electrode or the drain electrode and the first amorphous oxide semiconductor layer, as in the configurations shown in Figs. 1B and 1C, in particular, the upper limit of the above-described film thickness can be, for example, 30 nm or less. In the case where the film thickness is specified to be 30 nm or less, adequate electrical connection between the electrode and the first amorphous oxide semiconductor layer can be obtained.

According to aspects of the present invention, as for the amorphous oxide semiconductor film applied to the first amorphous oxide semiconductor layer 11a, a thin film having a resistivity within the range of $10^{-1}$ ($\Omega$cm) to $10^5$ ($\Omega$cm) can be used. A material having a carrier concentration within the range of $10^{19}$ to $10^{20}$ ($1/cm^3$) can be applied. The electron mobility can be more than 10 $cm^2/Vsec$.

[ As for the amorphous oxide semiconductor film applied to the second amorphous oxide semiconductor layer 11b, a thin film having a resistivity within the range of $10^1$ ($\Omega$cm) to $10^7$ ($\Omega$cm) can be used. A material having a carrier concentration within the range of $10^{12}$ to $10^{18}$ ($1/cm^3$) can be applied. In particular, $10^{16}$ ($1/cm^3$) or less can be employed. A normally-off transistor can be realized by reducing the carrier concentration of the second amorphous oxide semiconductor layer. The electron mobility can be more than 0.1 $cm^2/Vsec$, and in particular, 1 $cm^2/Vsec$ or more can be employed.

According to aspects of the present invention, the electron mobility of the material constituting the first amorphous oxide semiconductor layer 11a can be larger than the electron mobility of the material constituting the second amorphous oxide semiconductor layer 11b. In the case where the material having a large electron mobility is disposed while being in contact with the gate insulating layer, as described above, a TFT having a large field-effect mobility can be realized.

Furthermore, the carrier concentration of the material constituting the second amorphous oxide semiconductor layer 11b can be smaller than the carrier concentration of the material constituting the first amorphous oxide semiconductor layer 11a. In the case where the material having a small carrier concentration is disposed on the side away from the gate insulating layer, a TFT exhibiting excellent environmental stability and driving stability can be realized.

Moreover, regarding the configuration in which a part of the second amorphous oxide semiconductor layer is disposed between the source electrode or the drain electrode and the first amorphous oxide semiconductor layer, as in the configurations shown in Figs. 1B and 1C, in particular, adequate electrical connection between the electrode and the first amorphous oxide semiconductor layer can be conducted. In such a configuration, the resistivity of the material for the second amorphous oxide semiconductor layer 11b can be specified to be $10^5$ ($\Omega$cm) or less. In the case where such a configuration is employed, good electrical connection can be obtained.

Examples of laminated channel structure in the TFT according to aspects of the present invention can include a structure, in which an amorphous Zn-In-O based film is disposed as the first amorphous oxide semiconductor layer and an amorphous Zn-In-Ge(or Si)-O based film is disposed as the second amorphous oxide semiconductor layer. A metal composition ratio which can be employed in the laminated channel structure according to aspects of the present invention will be described below in detail. In the case where an In-Zn-O thin film is used for the first amorphous oxide semiconductor layer 11a, crystals or crystallinity increases when the atomic composition ratio of Zn, which is represented by Zn/(In + Zn), is 0.75 or more. In this case, it is believed that the electron mobility cannot be increased due to scattering of polycrystalline grain interfaces. In addition, in consideration of the electrical characteristics, a thin film having the atomic composition ratio, Zn/(In + Zn), of Zn of 0.3 or more, and less than 0.75 can be used, as described above.

However, as is shown later by an example, in order to produce a normally-on TFT having a high mobility, the atomic composition ratio of Z can be specified to be less than 0.4 on the basis of the atomic composition ratio of Z in the first amorphous oxide semiconductor layer.

Furthermore, in the case where a Zn-In-Ge-O thin film is used for the second amorphous oxide semiconductor layer 11b, as the atomic composition ratio, Ge/(In + Zn + Ge), of Ge increases, the resistance increases, and undesirably the resistance between the channel and the electrode increases. In addition, in consideration of the composition, which makes a good TFT operation possible over a wide In/Zn composition ratio, as described above, a thin film exhibiting a value of Ge/(In + Zn + Ge) of 0.01 or more, and 0.4 or less can be used. In particular, a thin film exhibiting a value of Ge/(In + Zn + Ge) of 0.03 or more, and 0.15 or less can be used.

Moreover, a configuration, in which the composition ratio, Zn/(In + Zn), of Zn contained in the first amorphous oxide semiconductor layer is the same as the composition ratio, Zn/(In + Zn), of Zn contained in the above-described second amorphous oxide semiconductor layer, is one of usable configurations. Regarding such a configuration, a laminated structure excellent in the continuity of physical properties (a depth of a valence band upper end, a depth of a conduction band lower end, and the like) between the two layers may be expected. In addition, regarding such a laminated structure, formation of a good interface can be expected. In particular, regarding the configuration in which a part of the second amorphous oxide semiconductor layer is disposed between the source electrode or the drain electrode and the first amorphous oxide semiconductor layer, as in the configurations shown in Figs. 1B and 1C, adequate electrical connection between the electrode and the first amorphous oxide semiconductor layer can be conducted. In such a configuration, good electrical connection between the first amorphous oxide semiconductor layer and the second amorphous oxide semiconductor layer can be conducted, and the first amorphous oxide semiconductor layer can be close to the conduction band lower end of the second amorphous oxide semiconductor layer. In such a configuration, the resistivity of the material for the above-described 11b can be specified to be $10^5$ ($\Omega$cm) or less. Regarding such a configuration, good electrical connection is made possible by the configuration, in which the values of Zn/(In + Zn) of the two layers are the same.

There are other advantages in production. Examples thereof include that in formation of the first amorphous oxide semiconductor layer, a material source (sputtering target) formed from ceramic, in which ZnO and In$_2$O$_3$ are mixed, is used and in formation of the second amorphous oxide semiconductor layer, simultaneous film formation is conducted by using the above-described material source and a material source formed from Ge. In the case where the above-described technique is used, the two layers can be formed continuously and, furthermore, the composition can be adjusted easily. In the continuous film formation as described above, the degree of vacuum in an apparatus can be maintained at 300 Pa or less, and 100 Pa or less where possible, throughout a first step to form a first amorphous oxide semiconductor layer and a second step to form a second amorphous oxide semiconductor layer, so that the interface between layers can be made clean.

Furthermore, the configuration, in which the compositions of two materials are close to each other, can have an advantage that cross contamination with elements in the individual layers does not occur easily.

Moreover, as described above, according to the findings of the present inventors, regarding the In-Zn-O single layer channel TFT, a good switching characteristic is obtained in the vicinity of the atomic composition ratio, which is represented by Zn/(In + Zn), of Zn of 0.6. In this connection, it is effective that an In-Zn-O thin film having the above-described composition is used for the second amorphous oxide semiconductor layer 11b and a thin film having Zn/(In + Zn) of less than 0.6 is used for the first amorphous oxide semiconductor layer.

In addition, it is enough that the channel layer according to aspects of the present invention includes at least the first and the second amorphous oxide semiconductor layers, and other layers are allowed to be disposed additionally. That is, a multilayer channel may be employed.

Furthermore, in aspects of the present invention, in the case where a material containing at least Zn and In is selected for the first amorphous oxide semiconductor layer and a material containing at least Zn, In, and Ge is selected for the second amorphous oxide semiconductor layer, the composition ratio can also be adjusted by the following method. That is, the composition ratio and the like of target materials are adjusted in such a way that the composition ratios (Zn/(In + Zn)) with respect to In and Zn of the first and the second amorphous oxide semiconductor layers become the same. Typically, target materials formed from Zn and In having the same composition ratio are used. Then, a Ge target is further used in combination for only the second amorphous oxide semiconductor layer, so that the composition ratio in the amorphous oxide semiconductor layer is adjusted. As described above, in the case where only In and Zn contained in each of the first and the second amorphous oxide semiconductor layers are noted, the composition ratio can be adjusted more easily by allowing the composition ratios, Zn/(In + Zn), of Zn in the individual layers to become the same.

In this connection, in aspects of the present invention, the above-described phrase "the composition ratios are the same" refers to that the composition ratios are substantially the same. That is, not only the case where the composition ratios are completely the same, but also the case where the difference in the composition ratio is within tolerance is included. According to the findings of the present inventors, even when there is a difference in the composition ratio, the effect according to embodiments of the present invention is exerted insofar as the difference is within 3%, and within 1% where possible.

According to aspects of the present invention, in the case where the step to form the first amorphous oxide semiconductor layer (first step) and the step to form the second amorphous oxide semiconductor layer (second step) are conducted continuously, the following condition can be satisfied. That is, according to the findings of the present inventors, the pressure in the inside (including a film formation chamber, transportation path, and the like) of an apparatus for forming the amorphous oxide semiconductor layer can be maintained within a predetermined range throughout the first step and the second step. Specifically, change or degradation of the characteristics of the film during formation of the amorphous oxide semiconductor film can be suppressed by maintaining a vacuum atmosphere at 300 Pa or less. In this connection, it may be particularly effective according to aspects of the present invention to maintain the vacuum atmosphere, in which the above-described pressure is 100 Pa or less.

Alternatively, the same effects can be obtained by maintaining an inert gas atmosphere throughout the first step and the second step instead of maintaining the vacuum atmosphere as described above. As for the inert gas, He, Ne, Ar, and the like can be used. However, gases other than them can be used insofar as the gas does not adversely affect the amorphous oxide semiconductor film. The pressure of the inert gas atmosphere is not specifically limited. The effects according to the present invention can be obtained at atmospheric pressure or lower. In particular, a pressure of 1,000 Pa or less, and especially 500 Pa or less can be employed.

Here, the configuration, in which the Zn-In-Ge-O based thin film is applied to the second amorphous oxide semiconductor layer, has been described. However, a Zn-In-O based film can be applied to the second amorphous oxide semiconductor layer, as an example. According to the findings of the present inventors, the In-Zn-O based thin film exhibits good environmental stability when the atomic composition ratio of Zn, which is represented by Zn/(In + Zn), is in the vicinity of 0.6. For example, an In-Zn-O thin film having such a composition can be used as the second amorphous oxide semiconductor layer 11b.

A configuration, in which an In-Zn-O based thin film having Zn/(In + Zn) of less than 0.6 is used as the first amorphous oxide semiconductor layer and an In-Zn-O based thin film having Zn/(In + Zn) in the vicinity of 0.6 is used as the second amorphous oxide semiconductor layer, is one of the effective configurations.

The above-described channel configuration has the laminated structure comprising two materials having different compositions. However, the structure is not limited to the two-layer structure and may be a multilayer channel structure having any number of layers.

That is, it is enough that the channel layer according to aspects of the present invention includes at least the first amorphous oxide semiconductor layer and the second amorphous oxide semiconductor layer, and any laminated configuration having at least three layers may be employed. Examples thereof include a configuration having a three-layer channel structure including the first amorphous oxide semiconductor layer formed from a Zn-In-O film, a second layer formed from a Zn-In-Ge-O film, and a third layer formed from a Zn-In-Si-O film and a configuration having a four-layer channel structure including the first amorphous oxide semiconductor layer formed from a Zn-In-O film, a second layer formed from a Zn-In-Ge-O film, a third layer formed from a Zn-In-O film, and a fourth layer formed from a Zn-In-Ge-O film. Furthermore, the above-described channel configuration has the laminated structure comprising two materials having different compositions. However, a configuration, in which the composition is changed continuously in a thickness direction, may be employed. Examples thereof include a configuration, in which the content of Ge(Si) increases continuously in such a way that the composition of a Zn-In-O film is varied to the composition of a Zn-In-Ge-O film.

A TFT having excellent electrical characteristics and exhibiting small element characteristic variations due to the composition can be produced by using the above-described laminated channel structure and combinations of the materials of the individual layers.

Gate insulating layer

According to aspects of the present invention, as for the gate insulating layer 12, silicon oxide SiOx or silicon nitride SiNx and silicon oxynitride $SiO_xN_y$ can be used. In this connection, examples of oxides, which can be used as the gate insulating layer according to aspects of the present invention, of other than silicon include $GeO_2$, $Al_2O_3$, $Ga_2O_3$, $Y_2O_3$, and $HfO_2$.

Among them, SiOx can form a good-quality film easily by a CVD method. The stability of a TFT by using SiOx is good.

According to aspects of the present invention, a leakage current between the source and the gate electrodes and between the drain and the gate electrodes can be controlled at about $10^{-12}$ A through the use of a thin film gate insulating member having an excellent insulating property.

In aspects of the present invention, the thickness of the gate insulating layer can be 50 to 300 nm.

Electrode

In aspects of the present invention, as for materials for the source electrode 13, the drain electrode 14, and the gate electrode 15, materials having high electrical conductivities can be used. In aspects of the present invention, metal electrodes of Pt, Au, Ni, W, Mo, Ag, and the like can be used. Alternatively, transparent electroconductive film of indium tin oxide (ITO), ZnO, and the like may be used. In this connection, the structure of the electrode used in aspects of the present invention may be a single layer structure. However, a cascade structure of a plurality of layers of Au, Ti, and the like may also be employed.

Substrate

A glass substrate, a plastic substrate, or a resin material, e.g., a plastic film, may be used as the substrate 10.

In aspects of the present invention, the above-described channel layer and the gate insulating layer can be transparent to the visible light.

Therefore, a thin film transistor, which is transparent as a whole in the visible light region, can be produced by selecting a material, which is transparent to the visible light, for the electrode.

Manufacturing method

As for the method for forming a channel layer, vapor deposition methods, e.g., a sputtering method (SP method), a pulse laser deposition method (PLD method), an electron beam deposition method (EB method), and an atomic layer deposition method, can be used. Among the vapor deposition methods, the SP method is appropriate in consideration of the mass productivity. However, the method for forming the film is not limited to these methods.

In the production process according to aspects of the present invention, film formation can be conducted while the temperature of the substrate is kept at room temperature without conducting intentional heating. According to this technique, a low-temperature production process of a transparent thin film transistor on a plastic substrate becomes feasible.

Since the driving force is high (the amount of current is large), the characteristics exhibited by the TFT according to embodiments of the present invention are desirable characteristics for a TFT to drive an organic LED (OLED).

In the case where a semiconductor apparatus (active matrix substrate) including such a thin film transistor is applied to a display apparatus, the aperture ratio thereof can increase because the transparent substrate and the amorphous oxide TFT are used.

In particular, in the use for an organic EL display, a configuration, in which light is taken also from the substrate side, (bottom emission) can be adopted.

It is believed that the semiconductor apparatus according to the present embodiment is applied to various uses, e.g., ID tags and IC tags.

Specifically, a display apparatus as an example of a semiconductor apparatus including the field-effect transistor according to the present embodiment will be described below in detail.

The display apparatus can be formed by connecting a drain electrode serving as an output terminal of the field-effect transistor according to the present embodiment to an electrode of a display element, e.g., an organic or inorganic electroluminescent (EL) element or a liquid crystal element. An example of a specific display apparatus configuration will be described below with reference to a sectional view of the display apparatus.

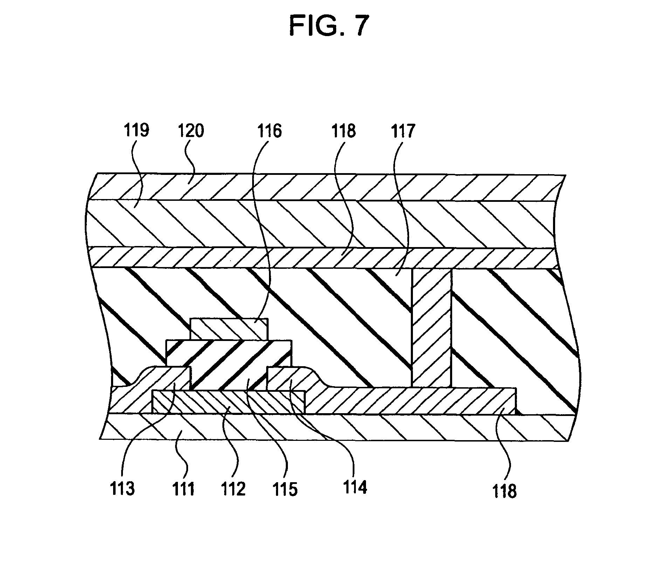

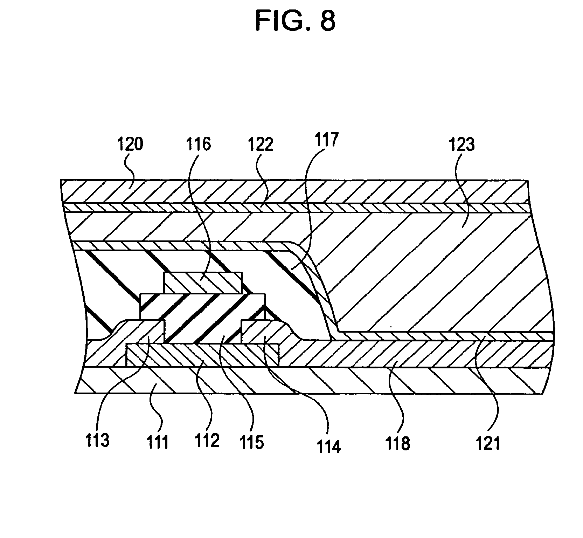

As shown in Fig. 7, a field-effect transistor comprising a channel layer 112, a source electrode 113, a drain electrode 114, a gate insulating film 115, and a gate electrode 116 is formed on a substrate 111. Here, in Fig. 7 and Fig. 8, the channel layer is expressed as one layer for the sake of simplicity, although the channel layer has a laminated structure, as described above. An electrode 118 is connected to the drain electrode 114 through an interlayer insulating layer 117. The electrode 118 is in contact with a light-emitting layer 119, and furthermore, the light-emitting layer 119 is in contact with an electrode 120. Such a configuration allows control of the current injected into the light-emitting layer 119 by the value of a current passing from the source electrode 113 to the drain electrode 114 through the channel, which is disposed in the channel layer 112. Therefore, this can be controlled by a voltage of the gate electrode 116 of the field-effect transistor. Here, the electrode 118, the light-emitting layer 119, and the electrode 120 constitute an inorganic or organic electroluminescent element.

As for another configuration, as shown in Fig. 8, a configuration, in which the drain electrode 114 is extended to double as the electrode 118 and, therefore, this serves as the electrode 118 to apply a voltage to a liquid crystal cell or an electrophoretic particle cell 123 sandwiched by high resistance films 121 and 122, can also be employed. The liquid crystal cell or the electrophoretic particle cell 123, the high resistance films 121 and 122, the electrode 118, and the electrode 120 constitute display elements. The voltage applied to these display elements can be controlled by the value of a current passing from the source electrode 113 to the drain electrode 114 through the channel, which is disposed in the channel layer 112. Therefore, this can be controlled by a voltage of the gate electrode 116 of the TFT. Here, if the display medium of the display element is a capsule, in which a fluid and particles are sealed into an insulating coating film, the high resistance films 121 and 122 are unnecessary.

In the above-described two examples, the thin film transistor is typified by the configuration of a stagger structure (top gate type). However, the present invention is not necessarily limited to the present configuration. For example, other configurations, e.g., a coplanar type, can be employed insofar as the connection between the drain electrode serving as an output terminal of the thin film transistor and the display element is topologically the same.

Furthermore, in the above-described two examples, the example, in which a pair of electrodes to drive the display element are disposed parallel to a base member, is shown in the drawing. However, the present embodiment is not necessarily limited to the present configuration. For example, any one of the electrodes or both electrodes may be disposed perpendicularly to the base member, insofar as the connection between the drain electrode serving as an output terminal of the thin film transistor and the display element is topologically the same.

Here, in the case where a pair of electrodes to drive the display element are disposed parallel to the base member, if the display element is an EL element or a reflective display element, e.g., a reflective liquid crystal element, it may be required that at least one of the electrodes is transparent to the wavelength of the emitted light or the wavelength of the reflected light. Alternatively, if the display element is a transmissive display element, e.g., a transmissive liquid crystal display element, it is required that both electrodes are transparent to the transmitted light.

Moreover, regarding the thin film transistor according to the present embodiment, all constituent members can be made transparent and, thereby, a transparent display element can be formed. In addition, the above-described display element can be disposed on a base member, e.g., light, flexible, transparent resin plastic, which exhibits low heat resistance.

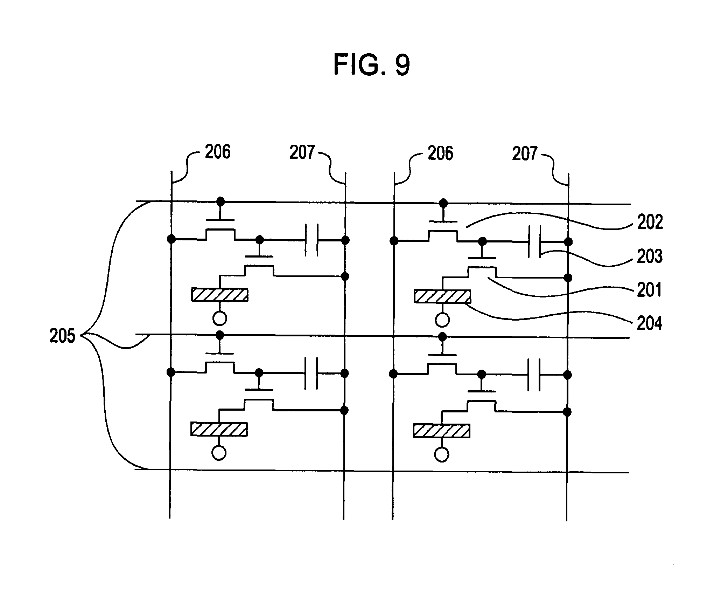

Next, a display element, in which a plurality of pixels including EL elements (here, organic EL elements) and field-effect transistors are arranged two-dimensionally, will be described with reference to Fig. 9.

In Fig. 9, a transistor 201 to drive an organic EL layer 204 and a transistor 202 to select a pixel are shown. A capacitor 203 keeps the selected state, stores electric charges between a common electrode line 207 and a source portion of the transistor 202, and holds the signal of a gate of the transistor 201. The selection of a pixel is determined by a scanning electrode line 205 and a signal electrode line 206.

A specific explanation will be made. An image signal as a pulse signal is applied from a driver circuit (not shown in the drawing) through the scanning electrode line 205 to the gate electrode. Likewise, at the same time, a pulse signal is applied from another driver circuit (not shown in the drawing) through the signal electrode line 206 to the transistor 202, so that a pixel is selected. At that time, the transistor 202 is turned ON, so that an electric charge is accumulated into the capacitor 203 located between the signal electrode line 206 and the source of the transistor 202. Consequently, the gate voltage of the transistor 201 is kept at a desired voltage and the transistor 201 is turned ON. This state is kept until a next signal is received. The voltage and the current continue to be supplied to the organic EL layer 204 so as to maintain light emission while the transistor 201 is in the ON state.

In the example shown in Fig. 9, the configuration includes two transistors and one capacitor per pixel. However, still more transistors and the like may be incorporated in order to improve the performance.

In production of the channel of the transistor, the composition of Zn:In of the first amorphous oxide semiconductor layer is changed within a predetermined range, and the composition of the Zn-In-Ge-O layer of the second amorphous oxide semiconductor layer is specified to be constant. Such a configuration is employed and, thereby, a bottom gate transistor of Example 1, as described below, can be produced. In this connection, as for the method for changing the above-described Zn:In ratio of the above-described first amorphous oxide semiconductor layer, films having different Zn:In ratios can be formed by changing the location of deposition of the substrate in film formation and, thereby, changing the relative distances between the substrate and the targets of $In_2O_3$ and ZnO.

Furthermore, differences in characteristics of the transistors can be expressed by differences in field-effect mobility $\mu$, threshold voltage (Vt), On Off current ratio, subthreshold swing value (S value), and the like.

Here, the field-effect mobility can be determined from characteristics of a linear region and a saturation region. Examples thereof include a method, in which a graph of √Id versus Vg is prepared on the basis of the result of a transfer characteristic, and the field-effect mobility is derived from the inclination thereof. In the present specification, the evaluation is conducted by this method unless otherwise specified.

Examples of some methods for determining the threshold voltage include a method, in which the threshold voltage Vt is derived from the x intercept of the graph of √Id versus Vg. Furthermore, the On Off current ratio can be determined from the ratio of the largest Id to the smallest Id in the transfer characteristic. Moreover, the subthreshold swing value can be derived from the reciprocal of the inclination of the graph of log(Id) versus Vd prepared on the basis of the result of the transfer characteristic. Besides, as for the switching voltage Vo, the voltage at the start of the leading edge of the current (gate voltage) in the transfer characteristic can be evaluated.

The differences between transistor characteristics can be indicated by other various parameters in addition to those described above.

Aspects of the present invention will be described below in further detail with reference to examples, although the present invention is not limited to them.

EXAMPLE 1

In the present example, a Zn-In-O based film was selected as the first amorphous oxide semiconductor layer 25a in Fig. 1C. Then, a Zn-In-Ge-O based semiconductor film was selected as the second amorphous oxide semiconductor layer 25b, and a bottom gate field-effect transistor including the channel layer 25 was produced.

Specifically, the above-described first amorphous oxide semiconductor layer 25a and the above-described second amorphous oxide semiconductor layer 25b were formed as a channel layer on a n$^+$-type Si substrate 21 provided with thermally oxidized $SiO_2$ (thickness 100 nm) serving as the gate insulator 22. The channel layer was formed in a sputtering chamber in a mixed atmosphere of argon and oxygen by using a high-frequency sputtering method. At this time, as for the patterning of the channel layer, pattern formation was conducted by using standard photolithography and a lift-off method.

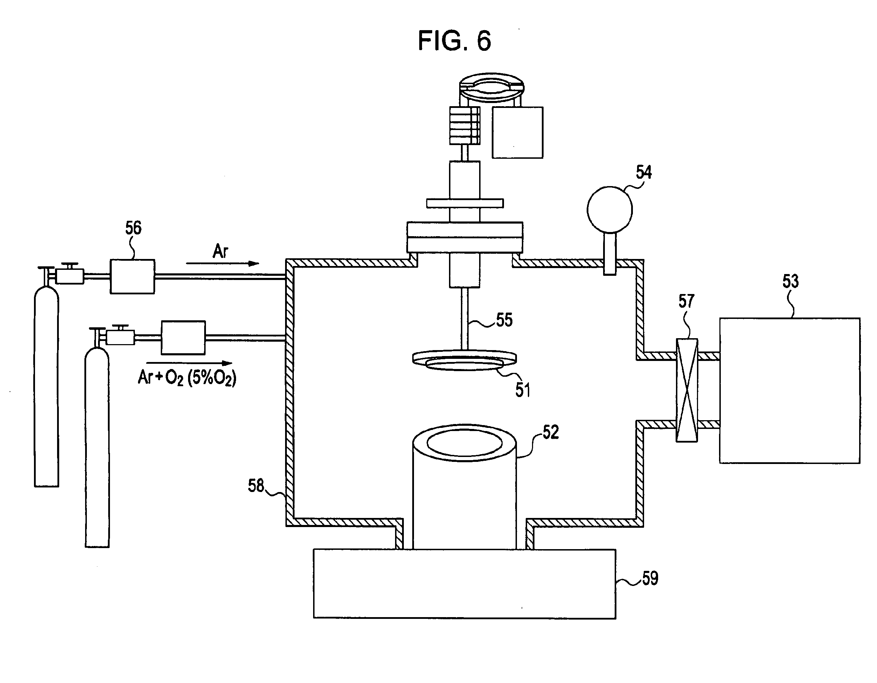

Fig. 6 is a diagram schematically showing a film formation system used for forming the channel layer of a field-effect transistor according to an embodiment of the present invention.

As shown in Fig. 6, the film formation system according to the present embodiment includes a gate valve 57 to control an evacuation capability and individual mass flow controllers 56 to control the amounts of the individual gases flowing into the system. Furthermore, a vacuum ion gauge 54, a substrate holder 55, a substrate 51, a turbo molecular pump 53, a film formation chamber 58, and a sputtering gun 52 with a sputtering target are included.

The turbo molecular vacuum pump 53 evacuates the film formation chamber 58 until $1 \times 10^{-5}$ Pa (back pressure) is reached.

The substrate holder 55 can adjust the position of the substrate in an x-y plane and a vertical z direction.

The sputtering gun 52 has an oxide target thereon. Besides them, cooling water is supplied to prevent the sputtering gun from being adversely affected by superheating, which occurs during film formation.

Reference numeral 59 denotes an RF power supply for the sputtering target and a matching network.

Regarding gas introduction pipes, each of an argon gas introduction pipe and a dilution oxygen gas (Ar:$O_2$ = 95:5) introduction pipe has one mass flow controller (MFC) 56.

Therefore, the atmosphere of the inside of the film formation chamber can be adjusted to become a predetermined atmosphere (total pressure and oxygen partial pressure) by controlling the inflow of argon and the dilution oxygen with the MFC 56 and controlling the pressure by using the control valve.

In the present example, initially, a first amorphous oxide semiconductor layer (Zn-In-O film) 11a was formed by simultaneous sputtering of a 2-inch $In_2O_3$ ceramic target and a 2-inch ZnO ceramic target. Subsequently, a second amorphous oxide semiconductor layer (Zn-In-Ge-O film) 11b was formed while a vacuum atmosphere was maintained within the range of 0.3 to 1 Pa. At this time, a 2-inch $In_2O_3$ ceramic target, a 2-inch $GeO_2$ ceramic target, and a 2-inch ZnO ceramic target were used as the targets, and the film formation was conducted through simultaneous sputtering.

During the film formation of the first amorphous oxide semiconductor layer, the RF power supply was maintained in such a way that a constant value (incidental deflections were permitted, the same goes for the following) of 35 W was applied to the $In_2O_3$ target and 46 W was applied to the ZnO target. Furthermore, during the film formation of the second amorphous oxide semiconductor layer, the RF power supply was maintained in such a way that an applied power was a constant value of 35 W for the $In_2O_3$ target, 30 W for the $GeO_2$ target, and 45 W for the ZnO target.

The total gas pressure and the flow rate ratio of Ar to $O_2$ during film formation were 0.4 Pa and 69:1, respectively. The film formation rates of the second and the first amorphous oxide semiconductor layer were about 11 nm/min and 9 nm/min, respectively, and the individual layers were formed having thicknesses of about 15 nm. In addition, the substrate temperature during the film formation was kept at room temperature (about 25°C).

Thereafter, a drain electrode 24 and a source electrode 23 were formed through patterning by a photolithography patterning method and a lift-off method. The source and the drain were layered structures of Au and Ti having thicknesses of 100 nm and 5 nm, respectively.

Furthermore, in the present example, the width and the length of the channel were specified to be 150 $\mu$m and 10 $\mu$m, respectively, and elements having different channel compositions were produced.

Evaluation of characteristics of TFT element

The voltage-current characteristic of the TFT formed following the above-described procedure was evaluated.

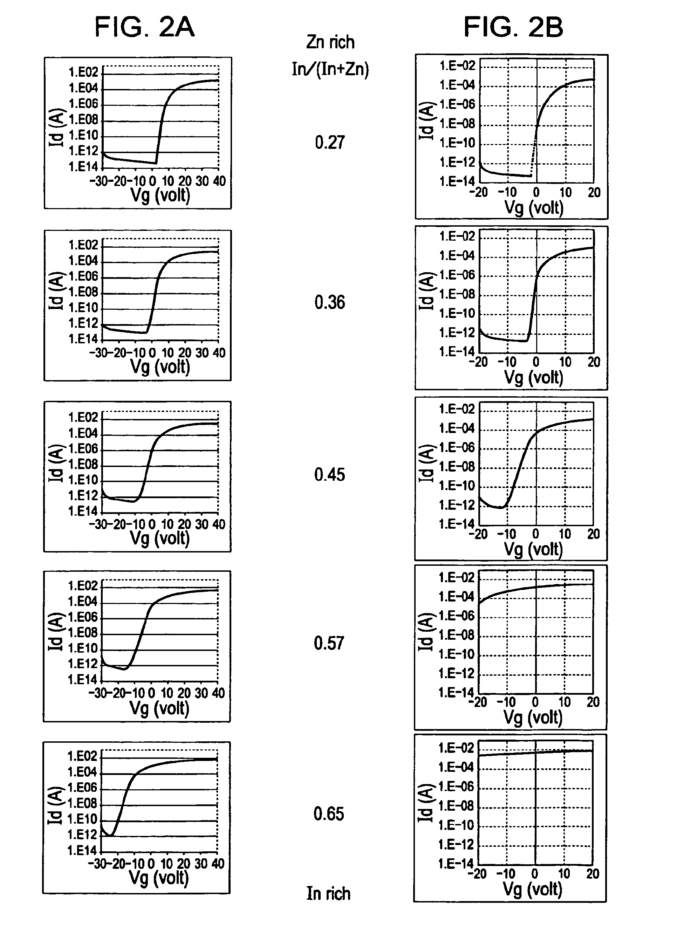

Fig. 2A is a graph showing the transfer characteristic, which was measured at room temperature, of the TFT formed from Zn-In-Ge-O/Zn-In-O (second amorphous oxide semiconductor layer/first amorphous oxide semiconductor layer) laminated channel of the present example. Here, five graphs are shown, in which In/(In + Zn) of the first amorphous oxide semiconductor layer 25a are within the range of 0.27 to 0.65 and are different from each other. The composition ratio In:Zn:Ge of the second amorphous oxide semiconductor layer 25b was about 42:45:13. The operation of the TFT was able to be ascertained over a wide In composition ratio of the first amorphous oxide layer.

As a comparative example, Fig. 2B shows the current-voltage characteristic of the TFT formed from a channel layer composed of one layer of Zn-In-O film having the same composition ratio as that of the above-described first amorphous oxide layer. As the composition ratio of In increased, the switching voltage decreased, and the operation as the TFT was not performed.

Fig. 3 is a graph showing the On Off current ratio of the TFT as a function of In/(In + Zn) of the first amorphous oxide semiconductor layer with respect to the laminated channel TFT of Example 1. For the purpose of comparison, the On Off current ratio of the TFT formed from a channel layer composed of one layer (single layer) of Zn-In-O is also shown. Here, the On and Off current values were measured at a gate voltage between 20 V and -20 V. It is clear that a high On Off ratio was obtained in a high In composition ratio region where no operation was performed with respect to one layer.

In Fig. 2, in the case where In/(In + Zn) of the first amorphous oxide layer is 0.27, a normally-off TFT, which exhibits a positive On voltage (may be referred to as switching voltage) Vo, is obtained. In the present example, it is estimated from this relationship of the dependence of Vo on the value of In/(In + Zn) that a TFT exhibiting a positive Vo can be realized in the case where In/(In + Zn) of the first amorphous oxide layer is about 0.3 or less. Furthermore, the TFT exhibiting an Off current of $10^{-12}$ or less was obtained in the case where In/(In + Zn) of the first amorphous oxide semiconductor layer was 0.57 or less.

Moreover, as is clear from Fig. 3, the TFT, which was a field-effect transistor exhibiting an On Off ratio of $10^9$ or more, was obtained in the case where In/(In + Zn) of the first amorphous oxide semiconductor layer was 0.55 or less.

Fig. 4 is a graph showing an example of the field-effect mobility $\mu$ ($cm^2$/Vsec) as a function of In/(In + Zn) of the first amorphous oxide semiconductor layer.

It was ascertained that the mobility of 15 to 25 $cm^2$/Vsec was realized without significant relation to changes in the In composition ratio. In particular, the TFT exhibiting a field-effect mobility $\mu$ of 20 $cm^2$/Vsec or more was obtained in the case where In/(In + Zn) of the first amorphous oxide layer was 0.35 or more. Furthermore, they were annealed in the air at 250 degrees for 1 hour and, thereby, a TFT exhibiting $\mu$ of 100 $cm^2$/Vsec or more was obtained in the case where In/(In + Zn) of the first amorphous oxide layer was 0.65 or more.

That is, excellent transfer characteristics can be realized by using the laminated channel formed from the first amorphous oxide semiconductor layer composed of Zn-In-O and the second amorphous oxide semiconductor layer composed of Zn-In-Ge-O, which is a new amorphous oxide semiconductor.

This indicates that a composition margin exhibiting a large On Off current ratio can be extended as compared with that of Zn-In-O based TFT, which has a large mobility but is significantly influenced by composition dependence, and thereby, excellent TFT characteristics can be realized.

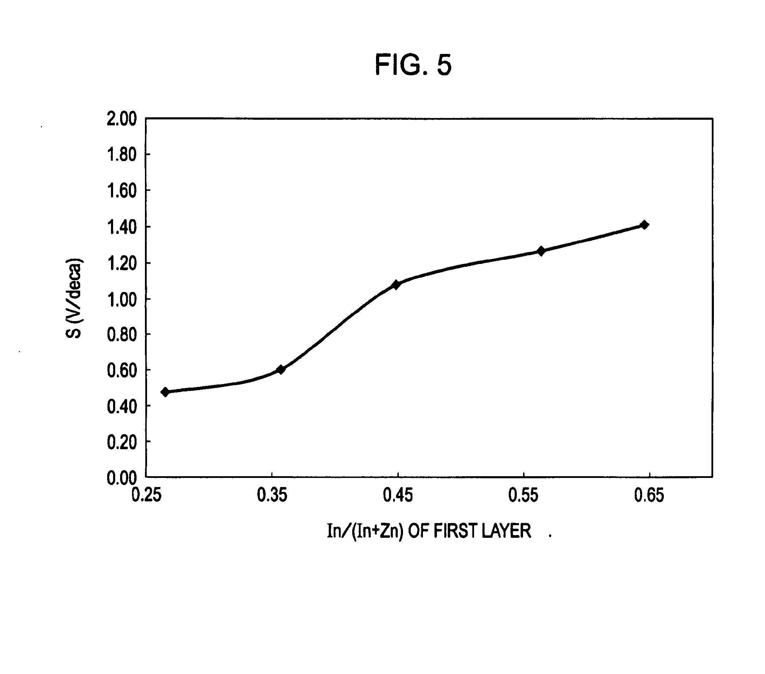

Fig. 5 shows In/(In + Zn) of the first amorphous oxide semiconductor layer versus the subthreshold swing value (S value) (V/dec). In Fig. 5, the TFT having the S value of 1 or less is realized in the case where In/(In + Zn) of the first amorphous oxide semiconductor layer is 0.35 or less. From this result, in the present example, it is estimated that a TFT having the S value of 1 or less can be realized in the case where In/(In + Zn) of the first amorphous oxide layer is 0.3 or less.

Since the TFT performance is good, it is promising that the In-Ge-O channel layer thin film transistor according to aspects of the present invention is used in an operation circuit of the OLED.

As described above, in Example 1, regarding the TFT transfer characteristics shown in Fig. 2A, the normally-off TFT, which exhibits a positive On voltage (may be referred to as switching voltage) Vo, is obtained in the case where In/(In + Zn) of the first amorphous oxide layer is 0.27. Therefore, it is estimated from this relationship of the dependence of Vo on the value of In/(In + Zn) that a TFT exhibiting a positive Vo can be realized in the case where In/(In + Zn) of the first amorphous oxide layer is about 0.3 or less. That is, the composition ratio, In/(In + Zn), of the first amorphous oxide semiconductor layer can be 0.3 or less from the viewpoint of realization of a normally-off TFT. Furthermore, the TFT exhibiting an Off current of $10^{-12}$ or less is obtained in the case where In/(In + Zn) of the first amorphous oxide semiconductor layer is 0.57 or less. That is, the composition ratio, In/(In + Zn), of the first amorphous oxide semiconductor layer can be 0.57 or less from the viewpoint of realization of a TFT exhibiting a small Off current.

Moreover, in Fig. 3, the TFT, which is a field-effect transistor exhibiting an On Off ratio of $10^9$ or more, is obtained in the case where In/(In + Zn) of the first amorphous oxide layer in Example 1 is 0.6 or less. That is, the composition ratio, In/(In + Zn), of the first amorphous oxide semiconductor layer in Example 1 can be about 0.6 or less, in particular 0.55 or less from the viewpoint of realization of a TFT exhibiting a large On Off ratio.

In addition, it is ascertained from Fig. 4 that in Example 1, the mobility of 15 to 25 cm$^2$/Vsec is realized without significant relation to changes in the In composition ratio. In particular, the TFT exhibiting a field-effect mobility $\mu$ of 20 cm$^2$/Vsec or more is obtained in the case where In/(In + Zn) of the first amorphous oxide layer is 0.35 or more. That is, the composition ratio, In/(In + Zn), of the first amorphous oxide semiconductor layer in Example 1 can be 0.3 or more from the above-described result and the viewpoint of realization of a TFT exhibiting a large field-effect mobility.

Furthermore, Fig. 5 shows In/(In + Zn) of the first amorphous oxide semiconductor layer versus the subthreshold swing value (S value) (V/dec). The TFT having the S value of 1 or less is obtained in the case where In/(In + Zn) of the first amorphous oxide semiconductor layer is 0.35 or less. From this result, in Example 1, it is estimated that a TFT having the S value of 1 or less can be realized in the case where In/(In + Zn) of the first amorphous oxide semiconductor layer is 0.4 or less. That is, the composition ratio, In/(In + Zn), of the first amorphous oxide semiconductor layer in Example 1 can be 0.4 or less from the viewpoint of realization of a TFT having a small S value.

EXAMPLE 2

In Example 2, the evaluation as in Example 1 was conducted by using the top gate field-effect transistor shown in Fig. 1A. Specifically, as for the channel layer, Zn-In-O was used as the first amorphous oxide layer 11a, and Zn-In-Ge-O was used as the second amorphous oxide layer 11b. In this manner, the top gate field-effect transistor shown in Fig. 1A was produced, and the evaluation was conducted as in Example 1. As a result, the effects of the thin film transistor according to aspects of the present invention were able to be ascertained as in Example 1.

EXAMPLE 3

In Example 3, the evaluation as in Example 1 was conducted by using the bottom gate field-effect transistor shown in Fig. 1B. Specifically, as for the channel layer, Zn-In-O was used as the first amorphous oxide layer 11a, and Zn-In-Ge-O was used as the second amorphous oxide layer 11b. In this manner, the bottom gate field-effect transistor including the gate insulating layer 12 and the semiconductor channel layer 11 on the gate electrode 15, as shown in Fig. 1B, was produced, and the evaluation was conducted as in Example 1. As a result, the effects of the thin film transistor according to aspects of the present invention were able to be ascertained as in Example 1.

EXAMPLE 4

In Example 4, the electrical properties of the first amorphous oxide semiconductor layer in Example 1 were shown. Table 1 (a) shows the results of evaluation of the hole mobility of the Zn-In-O film exhibiting In/(In + Zn) of 0.45. The production condition of the thin film was conformed to the film formation condition of the first amorphous oxide semiconductor layer in Example 1. The film thickness was 300 nm and an annealing treatment was conducted at 250°C in the air for 1 hour. It was ascertained on the basis of X-ray diffraction that the thin film was amorphous.

Next, the electrical properties of the second amorphous oxide semiconductor layer will be described. Table 1 (b) shows the results of evaluation of the hole mobility of the Zn-In-Ge-O film, in which In:Zn:Ge was 42:45:13. The production condition of the thin film was conformed to the film formation condition of the first amorphous oxide semiconductor layer in Example 1. The film thickness was about 300 nm and an annealing treatment was conducted at 250°C in the air for 1 hour. It was ascertained on the basis of X-ray diffraction that the thin film was amorphous.

As is clear from these results, the Zn-In-O film exhibits a larger mobility characteristic than that of the Zn-In-Ge-O film. It is clear that in the device configuration of Example 1, the electron mobility of the material for the first amorphous oxide semiconductor layer (Zn-In-O) is larger than the electron mobility of the material for the second amorphous oxide semiconductor layer (Zn-In-Ge-O). It is believed that in Example 1, a TFT exhibiting a large field-effect mobility can be realized by applying a material having a large electron mobility to the side in contact with the gate insulating layer (first amorphous oxide semiconductor layer).

Furthermore, the results of the present example show that the Zn-In-Ge-O film has a carrier concentration smaller than that of the Zn-In-O film. As is clear from these results, in the device configuration of Example 1, the carrier concentration of the material for the first amorphous oxide semiconductor layer is larger than the carrier concentration of the material for the second amorphous oxide semiconductor layer. It is believed that the TFT exhibiting a large On Off ratio was able to be realized by using a film, which had a low carrier concentration, for the second amorphous oxide semiconductor layer in spite of the fact that a material having a relatively large carrier concentration was applied to the side in contact with the gate insulating layer (first amorphous oxide semiconductor layer).

Table 1

| (a) InZnO film (In/(In + Zn) ≈ 0.45) film characteristics after annealing at 250°C in the air | |
|---|---|
| IZO (In/(In + Zn) ≈ 0.45 film after annealing at 250°C | |
| Resistivity ($\Omega$cm) | 0.32 |
| Mobility (cm$^2$/Vsec) | 26.7 |
| Carrier concentration (/cm$^3$) | -7.3E+17 |
| (b) InGeZnO film (In:Zn:Ge ≈ 42:45:13) film characteristics after annealing at 250°C in the air | |
| InGeZnO (In:Zn:Ge ≈ 42:45:13 film after annealing at 250°C) | |
| Resistivity ($\Omega$cm) | 6.78 |
| Mobility (cm$^2$/Vsec) | 12.1 |
| Carrier concentration (/cm$^3$) | -7.6E+16 |

EXAMPLE 5

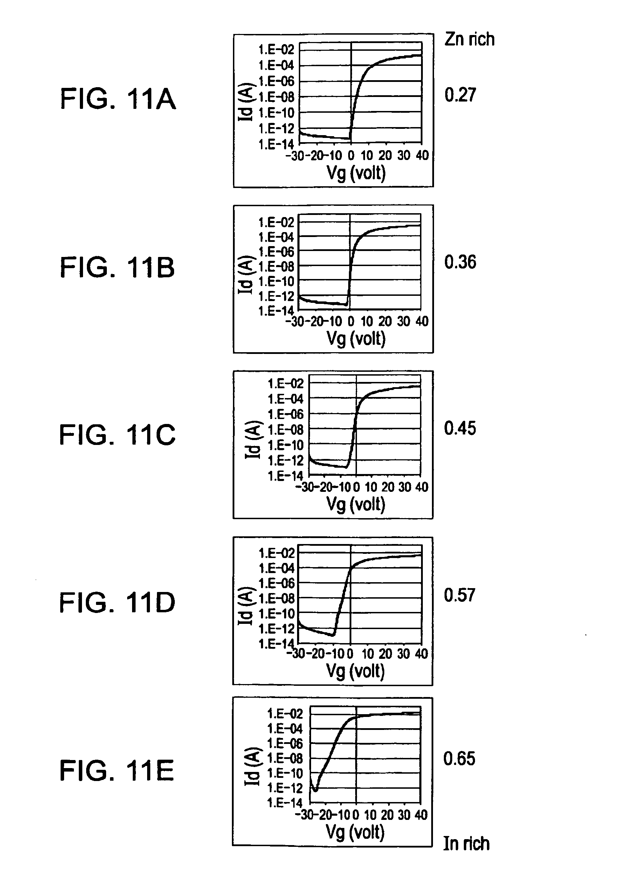

In Example 5, a thin film transistor produced as in Example 1 was succeedingly subjected to annealing in the air at 250°C for 1 hour, and the evaluation as in Example 1 was conducted. Fig. 11 is a graph showing the transfer characteristic of the TFT of the present example, measured at room temperature. Five graphs are shown, in which In/(In + Zn) of the first amorphous oxide semiconductor layer 11a are within the range of 0.27 to 0.65 and are different from each other. The composition ratio In:Zn:Ge of the second amorphous oxide semiconductor layer 11b was about 42:45:13. As in Example 1, the operation of the TFT was able to be ascertained in the case where the value of In/(In + Zn) of the first amorphous oxide semiconductor layer was 0.27 to 0.65.

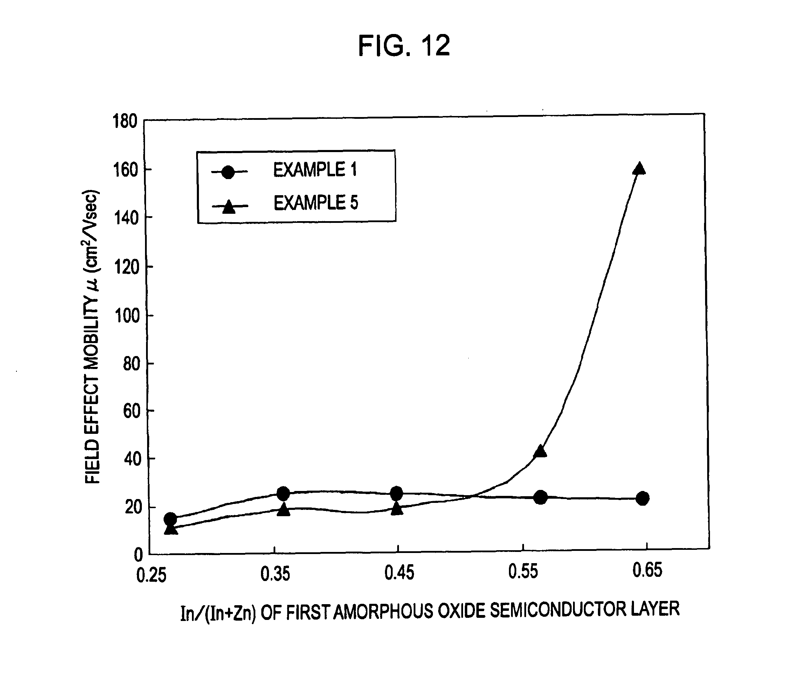

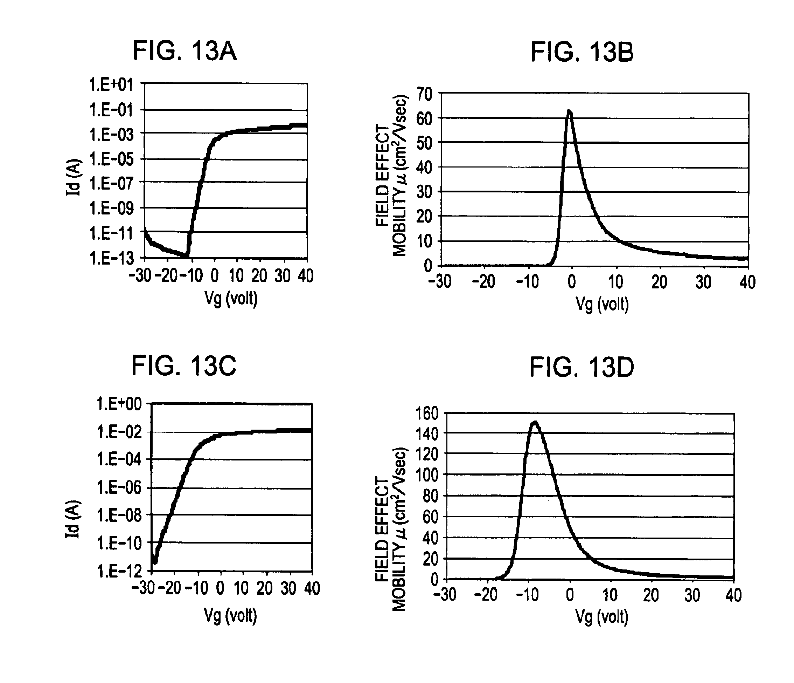

Furthermore, Fig. 12 is a graph showing an example of the field-effect mobility $\mu$ (cm$^2$/Vsec) as a function of In/(In + Zn) of the first amorphous oxide semiconductor layer in the present example. High field-effect mobilities were obtained with respect to the elements having large In composition ratios. In particular, the TFT exhibiting 150 cm$^2$/Vsec or more was obtained regarding the element, in which In/(In + Zn) of the first amorphous oxide semiconductor layer was 0.65. Moreover, regarding the TFTs in the case where In/(In + Zn) of the first amorphous oxide layer was about 0.57 and 0.65, the transfer characteristics thereof are shown in Figs. 13A and 13C, and the field-effect mobilities $\mu$ (cm$^2$/Vsec) are shown in Figs. 13B and 13D.

In the case where a TFT including a single layer channel is produced with respect to these In/(In + Zn) composition ratios (composition region in which the In composition is high), it is difficult to obtain an adequate Off state even when a negative gate voltage is applied. On the other hand, regarding the configuration of the present example, Id can be reduced to $10^{-10}$ A or less (turn Off) by applying a negative gate voltage.

In addition, as shown in Figs. 13B and 13D, the value of field-effect mobility exceeding 100 was obtained. As described above, in the present example, a high current can be transferred, so that there is a high possibility of use as a high mobility transistor.

That is, in the TFT including the laminated channel according to the present example, an oxide semiconductor having a large In content can be applied to the first amorphous oxide semiconductor layer. Consequently, a TFT having a large field-effect mobility at a level, which is difficult for a single layer channel structure to reach, can be realized.

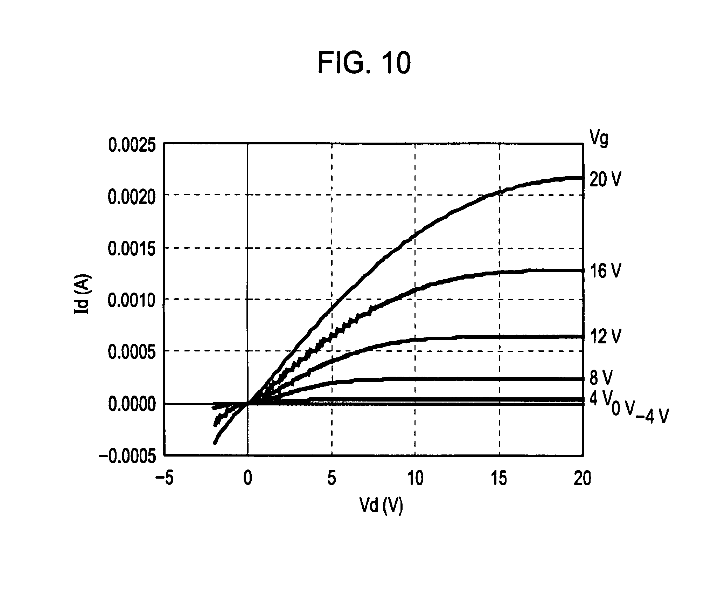

Furthermore, Fig. 10 shows the Id-Vd characteristic at a gate voltage of -4 V to 20 V. A pinch off characteristic (a phenomenon in which Id is saturated as Vd increases) is observed as a typical transistor characteristic.

EXAMPLE 6

Example 6 shows an example of a top gate field-effect transistor, as shown in Fig. 1A. Specifically, as for the channel layer, the first amorphous oxide semiconductor layer 11a was formed from Zn-In-O, and the second amorphous oxide semiconductor layer 11b was formed from Zn-In-Ge-O. The composition ratio in the first amorphous oxide semiconductor layer was In:Zn ≈ 40:60, and the composition ratio in the second amorphous oxide semiconductor layer was In:Zn:Ge ≈ 43:46:11.

Reference numeral 10 denotes a glass substrate, reference numerals 13 and 14 denote source and drain electrodes formed from Mo, reference numeral 12 denotes a gate insulating film formed from $SiO_x$, and reference numeral 15 denotes a gate electrode formed from Mo. When compared with Example 1, the two materials are laminated in a retrograde order. There is a commonality with Example 1 that the material on the side in contact with the gate insulating film is Zn-In-O.

A thin film transistor having a large mobility and exhibiting small characteristic variations due to composition ratio can be produced, as in Example 1, by applying such a laminated channel structure.

EXAMPLE 7

Example 7 shows an example of a bottom gate field-effect transistor, as shown in Fig. 1B. Specifically, as for the channel layer, the first amorphous oxide semiconductor layer 11a was formed from Zn-In-O, and the second amorphous oxide semiconductor layer 11b was formed from Zn-In-Si-O. The composition ratio in the first amorphous oxide semiconductor layer was In:Zn ≈ 38:62, and the composition ratio in the second amorphous oxide semiconductor layer was In:Zn:Si ≈ 44:47:9. Reference numeral 10 denotes a glass substrate, reference numerals 13 and 14 denote source and drain electrodes formed from Au/Ti, reference numeral 12 denotes a gate insulating film formed from $SiO_x$, and reference numeral 15 denotes a gate electrode formed from Mo.

A thin film transistor having a large mobility and exhibiting small characteristic variations due to composition ratio can be produced similarly to the bottom gate type configuration in Example 1 by applying such a laminated channel structure.

EXAMPLE 8

Example 8 is an example in which the driving stability of the laminated channel TFT according to aspects of the present invention was evaluated. In Example 8, A voltage (stress) was applied for a predetermined period to the element having the configuration according to Example 5 (the composition of the first amorphous oxide semiconductor layer Zn:In ≈ 36:64, the composition of the second amorphous oxide semiconductor layer In:Zn:Ge ≈ 42:45:13), and differences in TFT characteristics (transfer characteristic) between before and after the stress were compared. As for the voltage stress, a direct current voltage was used, and the gate voltage (Vg = 12 V) and the source drain voltage (Vd = 6 V) were applied at the same time. The voltage application time was 800 sec.

Differences in TFT characteristic parameters (Vo, S, Vt, μ) extracted from the transfer characteristics before and after the stress are shown in Table 2 (a). As a comparative example, the results of stress resistance measurement of the element formed from a Zn-In-O film single layer channel layer having the same composition ratio as that of the above-described first amorphous oxide semiconductor layer are also shown in Table 2 (b). In the comparative example, the shift of the switching voltage (Vo) was 0.64 V, whereas in the present example, the shift of Vo was significantly reduced to 0.33 V. Consequently, it is clear that the TFT according to the present example exhibits high stability toward the driving.

Table 2

| (a) Influence of DC stress on TFT in which In/(In + Zn) of the first amorphous oxide semiconductor layer of Example 5 ≈ 0.36 | | | |
|---|---|---|---|
| | Value before stress | Value after stress | Difference between before and after stress |
| Vo (V) | -1.07 | -0.74 | 0.33 |
| S (V/dec) | 0.40 | 0.39 | -0.01 |
| Vt (V) | 1.30 | 1.75 | 0.45 |
| μ ($cm^2$/Vsec) | 23.47 | 23.47 | 0.00 |

(continued)

| (b) Influence of DC stress on IZO single layer TFT (In/(In + Zn) $\approx$ 0.36) (after annealing at 250 degrees in the air for 1 hour) | | | |
|---|---|---|---|
| | Value before stress | Value after stress | Difference between before and after stress |
| Vo (V) | -1.18 | -0.54 | 0.64 |
| S (V/dec) | 0.41 | 0.42 | 0.01 |
| Vt (V) | 2.13 | 3.10 | 0.97 |
| $\mu$ (cm$^2$/Vsec) | 20.76 | 21.46 | 0.70 |
| TFT characteristic change in DC stress measurement (Vg = 12 V, Vd = 6 V, 800 sec) | | | |

REFERENCE EXAMPLE

The reference Example shows an example of a bottom gate field-effect transistor, as shown in Fig. 1C. Specifically, a Zn-In-O based film was selected as the first amorphous oxide semiconductor layer 11a of the channel layer. Then, a Zn-In-O based semiconductor film having the composition different from the first amorphous oxide semiconductor layer 11a was selected as the second amorphous oxide semiconductor layer 11b. The composition ratio, In/(In + Zn), of the first amorphous oxide semiconductor layer was 0.57, and the composition ratio, In/(In + Zn), of the second amorphous oxide semiconductor layer was 0.48.

The substrate 10 was a n$^+$-type Si substrate, the source and the drain electrodes 13 and 14 were formed from a layered structure of Au and Ti having thicknesses of 100 nm and 5 nm, respectively, and the gate insulating film 12 was formed from SiO$_x$.

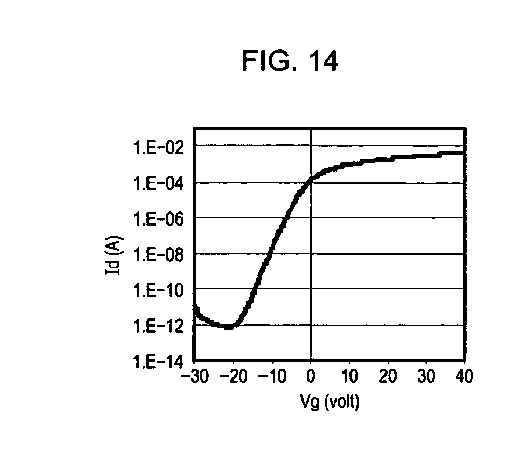

Fig. 14 is a graph showing the transfer characteristic of the TFT according to the present reference example, measured at room temperature. In the above-described comparative example, in the case where the In/(In + Zn) value of the channel layer was 0.57, the operation as the TFT was not performed, as shown in Fig. 2B. On the other hand, regarding the TFT of the present reference example, the operation was able to be ascertained, as shown in Fig. 14.

From the composition of the present reference example and the comparative example, it was ascertained that the laminated channel configuration allowed the TFT operation with respect to the composition ratio, In/(In + Zn), wider than that of the single layer channel configuration (comparative example).

A thin film transistor having a large mobility and exhibiting small characteristic variations due to composition ratio can be produced, as in Example 1, by applying such a laminated channel structure.

COMPARATIVE EXAMPLE

As a comparative example, Fig. 2B shows the current-voltage characteristic of the TFT formed from a channel layer composed of one layer of Zn-In-O film having the same composition ratio as that of the first amorphous oxide layer in Example 1. As the composition ratio of In increased, the switching voltage decreased, and the operation as the TFT was not performed.

In the present comparative example, regarding the elements having In/(In + Zn) of 0.27 and 0.36, the switching operation was performed. However, as the composition ratio of In increased (In/(In + Zn) was 0.45), the switching voltage Vo decreased. Furthermore, when In/(In + Zn) was 0.57 and 0.65, the operation as the TFT was not performed.

As is clear from the composition of Example 1 and the comparative example with reference to Fig. 2, the laminated channel configuration of the present example allowed the TFT operation with respect to the wider composition ratio, In/(In + Zn), as compared with that of the single layer channel configuration (comparative example).

Moreover, as is clear from the composition of the On Off ratio between Example 1 and the comparative example with reference to Fig. 3, the On Off ratio decreases with respect to the composition having a large In composition ratio in the comparative example (single layer Zn-In-O channel), whereas high On Off ratios are obtained over a wide composition range with respect to the laminated channel TFT in Example 1. That is, it can be said that in the present example, variations in TFT characteristics due to compositional variations are small.

That is, excellent transistor characteristics, in which TFT characteristics, e.g., the field-effect mobility and the On Off current ratio, are excellent and variations in element characteristics along with composition ratio variations are small, can be realized by using the laminated channel formed from the first amorphous oxide semiconductor layer composed of Zn-In-O and the second amorphous oxide semiconductor layer composed of Zn-In-Ge-O, which is a new amorphous oxide semiconductor.

While aspects of the present invention have been described with reference to exemplary embodiments, it is to be understood that the invention is not limited to the disclosed exemplary embodiments. The scope of the following claims is to be accorded the broadest interpretation so as to encompass all modifications, equivalent structures and functions.

**Claims**

1. A field-effect transistor comprising:

   a semiconductor layer (11) as a channel layer; and
   a gate electrode (15) disposed over the semiconductor layer with a gate insulating layer (12) therebetween,
   wherein the semiconductor layer (11) includes a first amorphous oxide semiconductor layer (11 a) comprising at least one element selected from the group consisting of Zn and In,
   **characterized in that**
   the semiconductor layer further comprises a second amorphous oxide semiconductor layer (11b) formed of a material having a composition different from the first amorphous oxide semiconductor layer and comprising at least one element selected from the group consisting of Ge and Si and at least one element selected from the group consisting of Zn and In,
   wherein the first amorphous oxide semiconductor layer is disposed between the gate insulating layer and the second amorphous oxide semiconductor layer.

2. The field-effect transistor according to Claim 1, wherein
   the first amorphous oxide semiconductor layer comprises Zn and In, and
   the second amorphous oxide semiconductor comprises Zn, In, and Ge.

3. The field-effect transistor according to Claim 2, wherein the composition ratio, Ge/(In + Zn + Ge), of Ge contained in the second amorphous oxide semiconductor layer is 0.01 or more, and 0.4 or less.

4. The field-effect transistor according to Claims 2 or 3, wherein the composition ratio, Ge/(In + Zn + Ge), of Ge contained in the second amorphous oxide semiconductor layer is 0.03 or more, and 0.15 or less.

5. The field-effect transistor according to any one of Claims 2 to 4, wherein the composition ratio, Zn/(In + Zn), of Zn contained in the first amorphous oxide semiconductor layer is 0.3 or more, and less than 0.75.

6. The field-effect transistor according to any one of Claims 2 to 4, wherein the composition ratio, Zn/(In + Zn), of Zn contained in the first amorphous oxide semiconductor layer is less than 0.4.

7. The field-effect transistor according to Claim 2, wherein the difference in the composition ratio, Zn/(In + Zn), of Zn contained in the first amorphous oxide semiconductor layer and the composition ratio, Zn/(In + Zn), of Zn contained in the second amorphous oxide semiconductor layer is within 3%.

8. The field-effect transistor according to any one of Claims 1 to 7, wherein a part of the second amorphous oxide semiconductor layer is disposed between a source electrode (13) or a drain electrode (14) and the first amorphous oxide semiconductor layer.

9. The field-effect transistor according to any one of Claims 1 to 7, wherein the gate insulating layer comprises a silicon oxide.

10. A method for manufacturing a field-effect transistor according to any one of Claims 1 to 9, the method comprising the steps of:

    forming the first amorphous oxide semiconductor layer (11a); and
    forming the second amorphous oxide semiconductor layer (11b),
    wherein the forming of the first amorphous oxide semiconductor layer (1 1a) and the forming of the second amorphous oxide semiconductor layer (11 b) are conducted in the same apparatus, and
    the pressure in the apparatus is maintained at 300 Pa or less in a vacuum atmosphere, or at atmospheric pressure or less in an inert gas atmosphere, throughout the forming of the first amorphous oxide semiconductor layer (11a) and the forming of the second amorphous oxide semiconductor layer (11b).

11. A display apparatus comprising:

the field-effect transistor (201) according to any one of Claims 1 to 9; and
an organic EL element (204) driven by the field-effect transistor (201).

**Patentansprüche**

1. Feldeffekttransistor, umfassend:

eine Halbleiterschicht (11) als eine Kanalschicht; und
eine Gate-Elektrode (15), die angeordnet ist über der Halbleiterschicht, und zwar mit einer Gate-Isolierschicht (12) dazwischen,
wobei die Halbleiterschicht (11) eine erste amorphe Oxidhalbleiterschicht (11a) beinhaltet, welche wenigstens ein aus der aus Zn und In bestehenden Gruppe ausgewähltes Element umfasst, **dadurch gekennzeichnet, dass**
die Halbleiterschicht ferner umfasst, nämlich eine zweite amorphe Oxidhalbleiterschicht (11b), die ausgebildet ist aus einem Material einer Zusammensetzung, welche sich von der ersten amorphen Oxidhalbleiterschicht unterscheidet, sowie wenigstens ein Element umfasst, welches ausgewählt ist aus der aus Ge und Si bestehenden Gruppe und wenigstens einem Element, das aus der der aus Zn und In bestehenden Gruppe ausgewählt ist,
wobei die erste amorphe Oxidhalbleiterschicht zwischen der Gate-Isolierschicht und der zweiten amorphen Oxidhalbleiterschicht angeordnet ist.

2. Feldeffekttransistor nach Anspruch 1, wobei
die erste amorphe Oxidhalbleiterschicht Zn und In umfasst und
die zweite amorphe Oxidhalbleiterschicht Zn, In und Ge umfasst.

3. Feldeffekttransistor nach Anspruch 2, wobei das Zusammensetzungsverhältnis, nämlich

$$Ge/(In + Zn + Ge),$$

vom in der zweiten amorphen Oxidhalbleiterschicht enthaltenem Ge 0,01 oder mehr und 0,4 oder weniger beträgt.

4. Feldeffekttransistor nach Anspruch 2 oder 3, wobei das Zusammensetzungsverhältnis, nämlich

$$Ge/(In + Zn + Ge),$$

vom in der zweiten amorphen Oxidhalbleiterschicht enthaltenem Ge 0,03 oder mehr und 0,15 oder weniger beträgt.

5. Feldeffekttransistor nach einem der Ansprüche 2 bis 4, wobei das Zusammensetzungsverhältnis, nämlich

$$Zn/(In + Zn),$$

vom in der ersten amorphen Oxidhalbleiterschicht enthaltenem Zn 0,3 oder mehr und weniger als 0,75 beträgt.

6. Feldeffekttransistor nach einem der Ansprüche 2 bis 4, wobei das Zusammensetzungsverhältnis, nämlich

$$Zn/(In + Zn),$$

vom in der ersten amorphen Oxidhalbleiterschicht enthaltenem Zn kleiner ist als 0,4.

7. Feldeffekttransistor nach Anspruch 2, wobei die Differenz in dem Zusammensetzungsverhältnis, nämlich

$$Zn/(In + Zn),$$

vom in der ersten amorphen Oxidhalbleiterschicht enthaltenem Zn sowie in dem Zusammensetzungsverhältnis, nämlich

$$Zn/(In + Zn),$$

vom in der zweiten amorphen Oxidhalbleiterschicht enthaltenem Zn innerhalb 3 % gelegen ist.

8. Feldeffekttransistor nach einem der Ansprüche 1 bis 7, wobei ein Teil der zweiten amorphen Oxidhalbleiterschicht angeordnet ist zwischen einer Source-Elektrode (13) oder einer Drain-Elektrode (14) und der ersten amorphen Oxidhalbleiterschicht.

9. Feldeffekttransistor nach einem der Ansprüche 1 bis 7, wobei die Gate-Isolierschicht ein Siliciumoxid umfasst.

10. Verfahren zum Herstellen eines Feldeffekttransistors nach einem der Ansprüche 1 bis 9, umfassend die Verfahrensschritte:

Ausbilden der ersten amorphen Oxidhalbleiterschicht (11a); und
Ausbilden der zweiten amorphen Oxidhalbleiterschicht (1 1 b),
wobei die Ausbildung der ersten amorphen Oxidhalbleiterschicht (1 1 a) und die der zweiten amorphen Oxidhalbleiterschicht (1 1 b) in derselben Apparatur ausgeführt werden, und
der Druck in der Apparatur bei 300 Pa oder weniger in einer Vakuumatmosphäre aufrechterhalten wird, oder bei atmosphärischem Druck oder weniger in einer Inertgasatmosphäre, und zwar während der gesamten Ausbildung der ersten amorphen Oxidhalbleiterschicht (11 a) und der Ausbildung der zweiten amorphen Oxidhalbleiterschicht (11 b).

11. Displayapparatur, umfassend:

den Feldeffekttransistor (201) nach einem der Ansprüche 1 bis 9;
und
ein organisches EL-Element (204), das vom
Feldeffekttransistor (201) betrieben wird.
W/Ar

## Revendications

1. Transistor à effet de champ comprenant :

une couche semi-conductrice (11) en tant que couche de canal ; et
une électrode (15) de grille disposée sur la couche semi-conductrice avec une couche (12) d'isolation de grille entre les deux,
dans lequel la couche semi-conductrice (11) inclut une première couche semi-conductrice (11a) d'oxyde amorphe comprenant au moins un élément choisi à partir du groupe constitué du Zn et de l'In,
**caractérisé en ce que** la couche semi-conductrice comprend en outre une seconde couche semi-conductrice (11b) d'oxyde amorphe faite d'une matière ayant une composition différente de la première couche semi-conductrice d'oxyde amorphe et comprenant au moins un élément choisi à partir du groupe constitué du Ge et du Si et au moins un élément choisi à partir du groupe constitué du Zn et de l'In,
dans lequel la première couche semi-conductrice d'oxyde amorphe est disposée entre la couche d'isolation de grille et la seconde couche semi-conductrice d'oxyde amorphe.

2. Transistor à effet de champ selon la revendication 1, dans lequel :

la première couche semi-conductrice d'oxyde amorphe comprend du Zn et de l'In, et

le second semi-conducteur d'oxyde amorphe comprend du Zn, de l'In et du Ge.

3. Transistor à effet de champ selon la revendication 2, dans lequel le rapport de composition, Ge/(In+Zn+Ge), du Ge contenu dans la seconde couche semi-conductrice d'oxyde amorphe est de 0,01 ou plus, et de 0,4 ou moins.

4. Transistor à effet de champ selon la revendication 2 ou 3, dans lequel le rapport de composition, Ge/(In+Zn+Ge), du Ge contenu dans la seconde couche semi-conductrice d'oxyde amorphe est de 0,03 ou plus, et de 0,15 ou moins.

5. Transistor à effet de champ selon l'une quelconque des revendications 2 à 4, dans lequel le rapport de composition, Zn/(In+Zn), du Zn contenu dans la première couche semi-conductrice d'oxyde amorphe est de 0,3 ou plus, et inférieur à 0,75.

6. Transistor à effet de champ selon l'une quelconque des revendications 2 à 4, dans lequel le rapport de composition, Zn/(In+Zn), du Zn contenu dans la première couche semi-conductrice d'oxyde amorphe est inférieur à 0,4.

7. Transistor à effet de champ selon la revendication 2, dans lequel la différence du rapport de composition, Zn/(In+Zn), du Zn contenu dans la première couche semi-conductrice d'oxyde amorphe et du rapport de composition, Zn/(In+Zn), du Zn contenu dans la seconde couche semi-conductrice d'oxyde amorphe est inférieur à 3 %.

8. Transistor à effet de champ selon l'une quelconque des revendications 1 à 7, dans lequel une partie de la seconde couche semi-conductrice d'oxyde amorphe est disposée entre une électrode (13) de source ou une électrode (14) de drain et la première couche semi-conductrice d'oxyde amorphe.

9. Transistor à effet de champ selon l'une quelconque des revendications 1 à 7, dans lequel la couche d'isolation de grille comprend un oxyde de silicium.

10. Procédé de fabrication d'un transistor à effet de champ selon l'une quelconque des revendications 1 à 9, le procédé comprenant les étapes :

de formation de la première couche semi-conductrice (11a d'oxyde amorphe ; et
de formation de la seconde couche semi-conductrice (11b) d'oxyde amorphe,
dans lequel la formation de la première couche semi-conductrice (11a) d'oxyde amorphe et la formation de la seconde couche semi-conductrice (11b) d'oxyde amorphe sont effectuées dans le même appareil, et
dans lequel la pression dans l'appareil est maintenue à 300 Pa ou moins dans une atmosphère sous vide, ou à la pression atmosphérique ou moins dans une atmosphère de gaz inerte, tout au long de la formation de la première couche semi-conductrice (11a) d'oxyde amorphe et de la formation de la seconde couche semi-conductrice (11b) d'oxyde amorphe.

11. Appareil d'affichage comprenant :

le transistor à effet de champ (201) selon l'une quelconque des revendications 1 à 9 ; et
un élément électroluminescent organique (204) attaqué par le transistor à effet de champ (201).

FIG. 1A

FIG. 1B

FIG. 1C

# FIG. 2A

Zn rich

In/(In+Zn)

# FIG. 2B

0.27

0.36

0.45

0.57

0.65

In rich

# FIG. 3

# FIG. 4

# FIG. 5

EP 2 197 034 B1

# FIG. 6

EP 2 197 034 B1

# FIG. 7

# FIG. 8

# FIG. 9

EP 2 197 034 B1

FIG. 10

FIG. 11A

Zn rich

0.27

FIG. 11B

0.36

FIG. 11C

0.45

FIG. 11D

0.57

FIG. 11E

0.65

In rich

## FIG. 12

EP 2 197 034 B1

# FIG. 13A

# FIG. 13B

# FIG. 13C

# FIG. 13D

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005199880 A1
- WO 2008133456 A1
- WO 2008133345 A1

- US 20080191204 A
- US 2008296568 A1

**Non-patent literature cited in the description**

- *Phys. stat. sol. (a,* 2008, vol. 205 (8), 1915-1919